# DEMANDE DE BREVET EUROPEEN

(11) **EP 4 210 187 A1**
(43) Date de publication de la demande: **12.07.2023**
(21) Numéro de dépôt: 22213988.3
(22) Date de dépôt: 15.12.2022
(51) Int. Cl.: H02G 15/34, H01B 12/16

(54) **CIRCUITS CÂBLÉS SUPRACONDUCTEURS COMPORTANT PLUSIEURS PORTIONS DE LONGUEUR DE CÂBLE SUPRACONDUCTEUR CONNECTÉES EN SÉRIE**

(30) Priorité: 07.01.2022 FR 2200110
(71) Demandeur: Nexans, 92400 Courbevoie (FR)
(72) Inventeur: SAUGRAIN, Jean-Maxime, 78110 Le Vésinet (FR); LALLOUET, Nicolas, 62360 Baincthun (FR)
(74) Mandataire: Ipsilon

(57) **Abrégé**

L'invention concerne un circuit électrique câblé supraconducteur comportant : deux portions (1a, 1b) comprenant chacune un coeur (2a, 2b) de câble supraconducteur, une couche d'isolation électrique (3a, 3b), un écran (4a, 4b) et une enveloppe cryogénique (5a, 5b) entourant l'écran (4a, 4b) pour permettre la circulation d'un fluide cryogénique; et au moins un premier arrangement (A) comprenant un boîtier cryostat de jonction (7) connectant électriquement en série les deux portions (1a, 1b), un canal (14) d'entrée/sortie pour fluide cryogénique, un module (12) de dérivation distinct comprenant au moins une dérivation (15) d'entrée/sortie de l'écoulement d'un fluide cryogénique dans la deuxième portion (1b); et un dispositif (13) de blocage de passage de fluide cryogénique interposé entre le canal (14) et ladite dérivation (15), et disposé autour et en contact de l'écran (4b) de la deuxième portion (1b).

## Description

### Domaine technique

La présente invention concerne le domaine général des circuits câblés supraconducteurs, et plus précisément les circuits câblés supraconducteurs comportant deux, voire plusieurs portions de longueur de câble supraconducteur connectées en série.

### Arrière-plan technologique

Un câble supraconducteur permet de transporter des courants électriques de forte intensité avec une section de câble beaucoup plus faible que celle d'un câble classique composé d'un conducteur électrique résistif, tout en limitant les pertes électriques le long du câble, notamment les pertes par effet Joule puisque ce phénomène disparaît dans l'état supraconducteur.

Un câble supraconducteur est classiquement constitué d'au moins un coeur de câble supraconducteur entouré par une couche d'isolation électrique, elle-même entourée d'un écran, le tout étant enfermé dans une enveloppe cryogénique. L'enveloppe cryogénique comporte par exemple deux enveloppes concentriques isolées thermiquement entre elles par du vide. Un fluide cryogénique, tel que de l'hélium ou de l'azote, sous forme liquide ou gazeuse, contenu à l'intérieur de l'enveloppe cryogénique, refroidit le fil supraconducteur central jusqu'à atteindre une température inférieure à la température dite critique pour laquelle ce fil passe dans un état de supraconductivité.

Il est connu d'utiliser des circuits câblés composés soit d'un unique câble supraconducteur de grande longueur, soit d'une pluralité de câbles supraconducteurs connectés les uns aux autres en série, de manière à réaliser un transport de courant de forte intensité sur une longue distance. Pour ce type de circuit, si le fluide cryogénique est injecté sous pression et à une température inférieure à la température critique à un point d'injection situé à une extrémité du circuit, il n'est pas garanti d'une part, que la pression reste suffisante pour permettre la circulation du fluide cryogénique sur toute la longueur du circuit, et d'autre part, que le fluide cryogénique ne s'échauffe pas pour atteindre une température supérieure à la température critique au fur et à mesure que l'on s'éloigne dans le circuit du point d'injection du fluide.

La solution technique la plus simple consiste à augmenter la section transversale du flux de fluide cryogénique tout au long du câble, à augmenter considérablement la pression initiale et à réduire la température minimale du fluide cryogénique lorsqu'il est injecté dans le système. Cela a cependant un impact énorme sur les spécifications et donc les coûts associés au système de refroidissement. De plus, il existe une limite technique si le circuit est très long : même avec un système de refroidissement utilisant la pression la plus élevée techniquement réalisable, avec une entrée à la température la plus basse possible avant la congélation du cryogène et avec la section la plus élevée possible de l'enveloppe cryogénique contenant le cryogène, la longueur maximale possible pour une conception de câble donnée sera limitée en raison de la physique.

Une autre solution consiste à diviser le circuit câblé supraconducteur en plusieurs sous-circuits : après une longueur de câble raisonnable donnée pour le système de refroidissement, le câble est arrêté avec une terminaison et un nouveau sous-circuit démarre avec une nouvelle terminaison et un nouveau système de refroidissement. Cette solution implique également une augmentation considérable des coûts sur des longueurs plurikilométriques, car elle nécessite une sorte de sous-station intermédiaire pour chaque "arrêt" du câble supraconducteur (travaux de génie civil supplémentaires, plusieurs terminaisons supplémentaires pour chaque "arrêt" du câble, courte liaison résistive entre chaque sous-système...).

### Résumé de l'invention

La présente invention a pour but de proposer des solutions pour circuits câblés supraconducteurs particulièrement adaptées pour une meilleure gestion des fluides cryogéniques, même en cas de longueurs importantes des circuits.

Plus particulièrement, la présente invention a pour objet un circuit électrique câblé supraconducteur comportant :
- une première portion de longueur de câble supraconducteur et une deuxième portion de longueur de câble supraconducteur, chacune des première et deuxième portions de longueur de câble supraconducteur comprenant un coeur de câble supraconducteur, une couche d'isolation électrique entourant le coeur de câble supraconducteur, un écran de blindage entourant la couche d'isolation électrique et une enveloppe cryogénique entourant l'écran pour permettre la circulation d'un fluide cryogénique dans un espace annulaire délimité par l'écran et l'enveloppe cryogénique; et
- au moins un premier arrangement comprenant un boîtier cryostat de jonction connectant électriquement en série la première portion et la deuxième portion, un canal d'entrée/sortie pour fluide cryogénique, et un dispositif de blocage de passage de fluide cryogénique disposé autour et en contact de l'écran de blindage de la deuxième portion de longueur de câble supraconducteur,
caractérisé en ce que ledit au moins un premier arrangement comprend en outre un module de dérivation distinct dudit boîtier cryostat de jonction et interposé entre le boîtier cryostat de jonction et la deuxième portion de longueur de câble supraconducteur, ledit module de dérivation comprenant au moins une dérivation d'entrée/sortie de l'écoulement d'un fluide cryogénique dans la deuxième portion de longueur de câble supraconducteur; et en ce que le dispositif de blocage de passage de fluide cryogénique est un disque en acier inoxydable ou en plastique renforcé de fibre de verre interposé entre ledit canal d'entrée/de sortie et ladite dérivation d'entrée/sortie.

Dans un mode de réalisation possible, ledit boîtier cryostat de jonction comprend :
- deux ouvertures d'accès au travers de chacune desquelles une extrémité de la première, respectivement de la deuxième, portion de longueur de câble supraconducteur peut s'étendre, chaque ouverture étant configurée pour permettre la fixation étanche d'une extrémité de l'enveloppe cryogénique de la portion correspondante de longueur de câble supraconducteur ; et
- un connecteur connectant électriquement les extrémités des deux coeurs de câble supraconducteur.

Dans un mode de réalisation possible, le dispositif de blocage dudit arrangement est disposé à l'intérieur du boîtier cryostat de jonction, en regard de l'ouverture d'accès traversée par la deuxième portion de longueur de câble et contre cette ouverture d'accès de manière à l'obturer, ledit boîtier cryostat de jonction portant en outre ledit canal d'entrée /sortie de fluide cryogénique.

En variante, le module de dérivation porte ledit canal d'entrée/sortie dudit arrangement, et le dispositif de blocage est disposé à l'intérieur du module de dérivation, entre ledit canal d'entrée/sortie et ladite dérivation d'entrée/sortie.

Le circuit peut comporter au moins un système de refroidissement relié au canal d'entrée /sortie et/ou à la dérivation d'entrée/sortie, de façon à recevoir un fluide cryogénique circulant à l'intérieur de l'une des portions de câble.

Dans un mode de réalisation possible, l'extrémité de la première, respectivement deuxième, portion de longueur de câble supraconducteur opposée à celle s'étendant dans le boîtier cryostat de jonction du premier arrangement est connectée à une première, respectivement deuxième, terminaison reliée électriquement à un réseau électrique, ledit au moins un système de refroidissement étant relié à la première terminaison via une première ligne de transfert cryogénique et audit premier arrangement via le canal d'entrée /sortie pour former une boucle fermée de circulation d'un premier fluide cryogénique, ledit au moins un système de refroidissement étant configuré pour refroidir et mettre sous pression le premier fluide cryogénique circulant dans la première portion de longueur de câble supraconducteur et reçu via le canal d'entrée/sortie et pour le réinjecter dans la première portion de longueur de câble supraconducteur via la première ligne de transfert cryogénique.

Le circuit peut alors en outre comporter un système de refroidissement additionnel relié à la deuxième terminaison via une deuxième ligne de transfert cryogénique et audit premier arrangement via la dérivation d'entrée /sortie pour former une boucle fermée de circulation d'un deuxième fluide cryogénique, ledit système de refroidissement additionnel étant configuré pour refroidir et mettre sous pression le deuxième fluide cryogénique circulant dans la deuxième portion de longueur de câble supraconducteur et reçu via la dérivation d'entrée/sortie et pour le réinjecter dans la deuxième portion de longueur de câble supraconducteur via la deuxième ligne de transfert cryogénique.

Dans un autre mode de réalisation possible, le système de refroidissement est relié directement au canal d'entrée /sortie et à la dérivation d'entrée/sortie dudit premier arrangement, ledit système de refroidissement étant configuré pour refroidir et mettre sous pression le fluide cryogénique circulant dans la première portion de longueur de câble supraconducteur et reçu via le canal d'entrée/sortie et pour le réinjecter dans la deuxième portion de longueur de câble supraconducteur via la dérivation d'entrée/sortie.

L'extrémité de la première, respectivement deuxième, portion de longueur de câble supraconducteur opposée à celle s'étendant dans le boîtier cryostat de jonction dudit premier arrangement peut en outre être connectée à une première, respectivement deuxième, terminaison reliée électriquement à un réseau électrique.

Le circuit peut alors comporter un système de refroidissement additionnel relié à la première terminaison via une première ligne de transfert cryogénique et à la deuxième terminaison via une deuxième ligne de transfert cryogénique pour former une boucle fermée de circulation du fluide cryogénique, ledit système de refroidissement additionnel étant configuré pour refroidir et mettre sous pression le fluide cryogénique circulant dans la deuxième portion de longueur de câble supraconducteur et reçu via la deuxième ligne de transfert cryogénique et pour le réinjecter dans la première portion de longueur de câble supraconducteur via la première ligne de transfert cryogénique.

Dans un autre mode de réalisation possible, le circuit comprend :
- une troisième portion de longueur de câble supraconducteur comprenant un coeur de câble supraconducteur, une couche d'isolation électrique entourant le coeur de câble supraconducteur, un écran entourant la couche d'isolation électrique et une enveloppe cryogénique entourant l'écran pour permettre la circulation d'un fluide cryogénique dans un espace annulaire délimité par l'écran et l'enveloppe cryogénique ; et
- un deuxième arrangement comprenant un boîtier cryostat de jonction connectant électriquement en série la troisième portion et l'extrémité de la première portion opposée à celle s'étendant dans le boîtier cryostat de jonction du premier arrangement, un canal d'entrée/sortie pour fluide cryogénique, un module de dérivation comprenant au moins une dérivation d'entrée/sortie de l'écoulement d'au moins un fluide cryogénique dans la première portion de longueur de câble supraconducteur; et un dispositif de blocage de passage de fluide cryogénique interposé entre ledit canal d'entrée/ sortie du deuxième arrangement et ladite dérivation d'entrée/sortie du deuxième arrangement, le dispositif de blocage étant disposé autour et en contact de l'écran de la première portion de longueur de câble supraconducteur,
dans lequel le système de refroidissement est relié directement au canal d'entrée /sortie du premier arrangement et à la dérivation d'entrée/sortie du deuxième arrangement pour former une boucle fermée de circulation d'un premier fluide cryogénique, ledit système de refroidissement étant configuré pour refroidir et mettre sous pression le premier fluide cryogénique circulant dans la première portion de longueur de câble supraconducteur et reçu via le canal d'entrée/sortie du premier arrangement et pour le réinjecter dans la première portion de longueur de câble supraconducteur via la dérivation d'entrée/sortie du deuxième arrangement.

Le circuit peut alors comporter :
- une quatrième portion de longueur de câble supraconducteur comprenant un coeur de câble supraconducteur, une couche d'isolation électrique entourant le coeur de câble supraconducteur, un écran entourant la couche d'isolation électrique et une enveloppe cryogénique entourant l'écran pour permettre la circulation d'un fluide cryogénique dans un espace annulaire délimité par l'écran et l'enveloppe cryogénique ;
- un troisième arrangement comprenant un boîtier cryostat de jonction connectant électriquement en série la quatrième portion et l'extrémité de la deuxième portion opposée à celle s'étendant dans le boîtier cryostat de jonction du premier arrangement, un canal d'entrée/sortie pour fluide cryogénique, un module de dérivation comprenant au moins une dérivation d'entrée/sortie de l'écoulement d'au moins un fluide cryogénique dans la quatrième portion de longueur de câble supraconducteur; et un dispositif de blocage de passage de fluide cryogénique interposé entre ledit canal d'entrée/ sortie du troisième arrangement et ladite dérivation d'entrée/sortie du troisième arrangement, le dispositif de blocage étant disposé autour et en contact de l'écran de la quatrième portion de longueur de câble supraconducteur ; et
- un système de refroidissement additionnel relié directement au canal d'entrée /sortie du troisième arrangement et à la dérivation d'entrée/sortie du premier arrangement pour former une boucle fermée de circulation d'un deuxième fluide cryogénique, ledit système de refroidissement additionnel étant configuré pour refroidir et mettre sous pression le deuxième fluide cryogénique circulant dans la deuxième portion de longueur de câble supraconducteur et reçu via le canal d'entrée/sortie du troisième arrangement et pour le réinjecter dans la deuxième portion de longueur de câble supraconducteur via la dérivation d'entrée/sortie du premier arrangement.

Dans un autre mode de réalisation possible du circuit électrique, l'extrémité de la première, respectivement deuxième, portion de longueur de câble supraconducteur opposée à celle s'étendant dans le boîtier cryostat de jonction du premier arrangement est connectée à une première, respectivement deuxième, terminaison reliée électriquement à une phase d'un réseau électrique.

Un système triphasé peut comprendre trois de ce circuit électrique câblé supraconducteurs définissant chacun une phase du système.

Dans un mode de réalisation possible d'un tel système triphasé, le premier arrangement d'une première phase parmi les trois phases du système comporte un canal d'entrée/sortie additionnel et une dérivation d'entrée/sortie additionnelle, et est connecté aux premiers arrangements de chacune des deux autres phases de façon à ce que :
- son canal d'entrée/sortie et sa dérivation d'entrée/sortie soient connectés respectivement au canal d'entrée/sortie et à la dérivation du premier arrangement associé à une deuxième phase parmi les trois phases ;
- son canal d'entrée/sortie additionnel et sa dérivation d'entrée/sortie additionnelle soient connectés respectivement au canal d'entrée/sortie et à la dérivation d'entrée/sortie du premier arrangement associé à une troisième phase parmi les trois phases.

Un tel système triphasé peut en outre comporter :
- un premier système de refroidissement injectant un premier flux principal de fluide cryogénique dans la première portion de longueur de câble de la première phase à travers la terminaison correspondante ;
- un second système de refroidissement injectant un second flux principal de fluide cryogénique dans la deuxième portion de longueur de câble de la première phase à travers la terminaison correspondante. dans lequel le premier, respectivement le deuxième, flux principal est divisé par le premier arrangement de la première phase en deux demi-flux, puis recombinés par le premier, respectivement le deuxième, système de refroidissement pour être réinjectés de nouveau, après réajustement de la pression et de la température, dans la première, respectivement la deuxième, portion de longueur de câble de la première phase.

### Brève description des figures

La description qui va suivre en regard des dessins annexés, donnés à titre d'exemples non limitatifs, fera bien comprendre en quoi consiste l'invention et comment elle peut être réalisée. Sur les figures annexées :
[fig. 1] La figure 1 illustre schématiquement et partiellement un exemple de circuit électrique câblé supraconducteur selon un premier mode de réalisation conforme à l'invention ;
[fig. 2] La figure 2 illustre schématiquement et partiellement un exemple de circuit électrique câblé supraconducteur selon un deuxième mode de réalisation conforme à l'invention ;
[fig. 3] La figure 3 représente une première configuration possible pour la gestion du refroidissement et de la pression de fluides cryogéniques pour un exemple de circuit électrique câblé supraconducteur ;
[fig. 4] La figure 4 représente une deuxième configuration possible pour la gestion du refroidissement et de la pression de fluides cryogéniques pour un exemple de circuit électrique câblé supraconducteur ;
[fig. 5] La figure 5 représente une troisième configuration possible pour la gestion du refroidissement et de la pression de fluides cryogéniques pour un exemple de circuit électrique câblé supraconducteur ;
[fig. 6] La figure 6 représente une configuration possible pour la gestion du refroidissement et de la pression de fluides cryogéniques pour un exemple de système électrique triphasé.

### Description de mode(s) de réalisation

Dans les figures, les éléments identiques ou équivalents porteront les mêmes signes de référence. Les différents schémas ne sont pas à l'échelle.

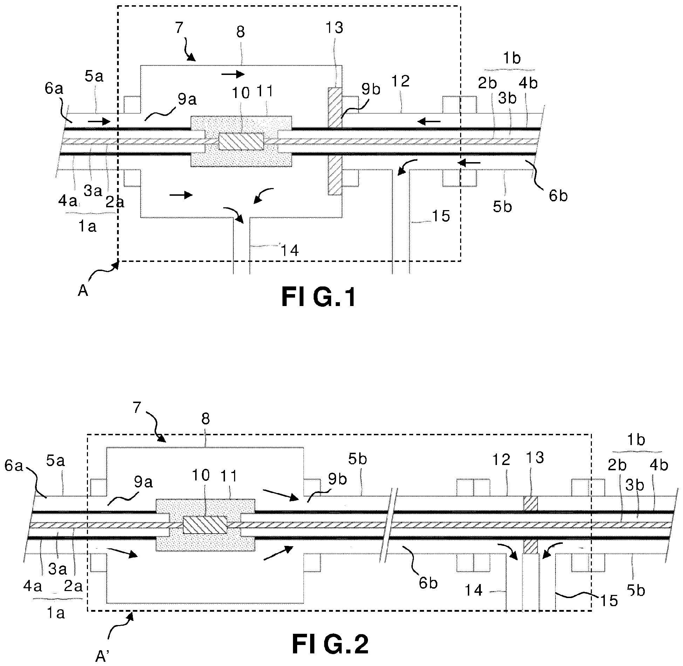

La figure 1 illustre schématiquement et partiellement un circuit électrique câblé supraconducteur comportant deux portions de longueur de câble supraconducteur connectées en série selon un premier mode de réalisation conforme à l'invention.

Plus précisément, le circuit comprend, dans l'exemple non limitatif schématisé sur la figure 1, une première portion 1a de longueur de câble supraconducteur et une deuxième portion 1b de longueur de câble supraconducteur. Dans la suite, la lettre « a » sera ajoutée aux références numériques relatives à la portion 1a de longueur de câble, et la lettre « b » sera ajoutée aux références numériques relatives à la portion 1b de longueur de câble. Chaque portion 1a, 1b de longueur de câble supraconducteur comprend, en allant de l'élément le plus interne au câble à l'élément le plus externe :
- un coeur 2a, 2b de câble supraconducteur,
- une couche d'isolation électrique 3a, 3b entourant le coeur 2a, 2b de câble supraconducteur,
- un écran 4a, 4b entourant la couche d'isolation électrique 3a, 3b et servant de blindage électromagnétique, et
- une enveloppe cryogénique 5a, 5b entourant l'écran 4a, 4b pour permettre la circulation d'un fluide cryogénique dans un espace annulaire 6a, 6b délimité par l'écran 4a, 4b et la surface interne de l'enveloppe cryogénique 5a, 5b.

Le coeur 2a, 2b comprend par exemple un élément longitudinal métallique (par exemple un ou plusieurs brins de cuivre) entouré d'au moins une couche supraconductrice (formée par exemple de plusieurs fils ou rubans supraconducteurs).

La couche d'isolation électrique 3a, 3b est constituée par exemple de plusieurs couches de rubans isolants de type PPLP (initiales anglo-saxonnes mises pour Poly Propylene Laminated Paper).

L'écran 4a, 4b est constitué par exemple de rubans cuivre et ceux-ci peuvent également être associés à des rubans supraconducteurs.

L'enveloppe cryogénique 5a, 5b comporte de préférence deux enveloppes concentriques (non représentées), préférentiellement constituées d'acier inoxydable corrugué, isolées thermiquement entre elles par du vide. Comme indiqué précédemment, l'espace 6a, 6b délimité par l'écran 4a, 4b et la surface interne de l'enveloppe cryogénique 5a, 5b est un espace annulaire de la portion 1a, 1b de longueur de câble supraconducteur, à l'intérieur duquel un fluide cryogénique peut s'écouler. Le fluide cryogénique, tel que de l'hélium ou de l'azote, sous forme liquide ou gazeuse, circulant à l'intérieur de l'enveloppe cryogénique 5a, 5b, doit refroidir le coeur 2a, 2b jusqu'à atteindre une température inférieure à la température dite critique pour laquelle ce coeur passe dans un état de supraconductivité.

Les deux portions 1a, 1b de longueur de câble supraconducteur peuvent provenir d'un même câble, ou de câbles différents. Par ailleurs, les fluides cryogéniques circulant dans les deux portions 1a, 1b peuvent être les mêmes fluides ou des fluides différents.

Dans tous les cas, les deux portions 1a, 1b de longueur de câble supraconducteur sont connectées en série par l'intermédiaire d'un arrangement A comprenant un boîtier cryostat de jonction 7 recevant une extrémité de chacune des deux portions 1a, 1b. L'enveloppe externe 8 du boîtier cryostat de jonction 7 est une enveloppe cryogénique, constituée de préférence, à l'instar des portions 1a, 1b de longueur de câble supraconducteur, d'une enveloppe interne et d'une enveloppe externe (non représentées) isolées thermiquement entre elles par du vide.

Pour permettre la connexion en série des deux portions 1a, 1b de longueur de câble supraconducteur, le boîtier cryostat 7 comporte deux ouvertures 9a, 9b d'accès au boîtier cryostat 7, situées par exemple en regard l'une de l'autre, et au travers desquelles les extrémités des portions 1a, 1b de longueur de câble peuvent s'étendre. Chaque ouverture 9a, 9b d'accès est configurée pour permettre la fixation étanche d'une extrémité de l'enveloppe cryogénique 5a, 5b de la portion 1a, 1b de longueur de câble qui lui est rattachée. Comme on le voit sur la figure 1, l'enveloppe cryogénique 5a, 5b a été retirée sur la portion de longueur d'extrémité de la portion 1a, 1b qui pénètre à l'intérieur du boîtier 7. Le boîtier cryostat de jonction 7 renferme en outre un connecteur 10 permettant de réaliser la connexion électrique en série des deux extrémités des coeurs 2a, 2b de câble supraconducteur. Comme on le voit sur la figure 1, des portions d'extrémité de l'écran 4a, 4b, et de la couche d'isolation électrique 3a, 3b ont été retirées pour permettre aux seules extrémités des coeurs 2a, 2b d'être reliées électriquement par le connecteur 10.

Le connecteur 10 est de préférence entouré par un dispositif 11 apte à supporter le champ électrique entre le connecteur 10 (à la tension) et les écrans 4a et 4b (au potentiel de la terre). Ce dispositif 11 permet d'assurer la continuité de l'isolation électrique et la continuité électrique des écrans entre la portion 1a et 1b. Un tel dispositif est par exemple décrit dans le document EP2105994A1.

L'arrangement A schématisé sur la figure 1 comprend également :
- un canal 14 d'entrée/sortie pour fluide cryogénique,
- un module 12 de dérivation comprenant au moins une dérivation 15 d'entrée/sortie de l'écoulement d'un fluide cryogénique dans la deuxième portion 1b de longueur de câble supraconducteur ; et
- un dispositif 13 de blocage de passage de fluide cryogénique, interposé entre le canal 14 d'entrée/de sortie et la dérivation 15 d'entrée/sortie, et disposé autour et en contact de l'écran 4b de la deuxième portion 1b de longueur de câble supraconducteur.

Le module 12 de dérivation est traversé sans discontinuité par l'extrémité de la deuxième portion 1b de câble comportant le coeur 2b, la couche d'isolation 3b et l'écran 4b, pour que ces derniers puissent pénétrer à l'intérieur du boîtier 7. Le module 12 de dérivation comporte également une enveloppe cryogénique pour assurer la continuité de l'écoulement de fluide cryogénique.

Le dispositif 13 de blocage est par exemple un disque en acier inoxydable ou en plastique renforcé de fibre de verre. Dans un mode de réalisation possible, l'étanchéité entre ce dispositif 13 de blocage et l'écran 4b est renforcée par l'injection d'une résine époxy.

Dans le mode de réalisation de la figure 1, le dispositif 13 de blocage est disposé à l'intérieur du boîtier cryostat de jonction 7 de l'arrangement A, de préférence en regard de l'ouverture d'accès 9b traversée par la deuxième portion 1b, et contre cette ouverture d'accès 9b de manière à obturer cette ouverture. Il empêche ainsi d'une part, au fluide cryogénique contenu dans le boîtier 7, de pénétrer à l'intérieur de l'enveloppe cryogénique du module 12 de dérivation, et d'autre part, au fluide cryogénique contenu dans la deuxième portion 1b de câble de pénétrer à l'intérieur du boîtier 7.

Le boîtier cryostat de jonction 7 porte en outre le canal 14 d'entrée/sortie de fluide de l'arrangement A. Dans l'exemple non limitatif de la figure 1 et comme représenté par les flèches, le canal 14 est utilisé comme une sortie du fluide cryogénique circulant dans la première portion 1a de câble puis dans le boîtier 7, et la dérivation 15 est utilisée comme une sortie du fluide cryogénique circulant dans la deuxième portion 1b de câble puis dans le module 12 de dérivation.

La figure 2 illustre schématiquement et partiellement un circuit électrique câblé supraconducteur selon un deuxième mode de réalisation conforme à l'invention. Ce deuxième mode ne diffère du premier mode de la figure 1 que sur les aspects suivants :
- le boîtier cryostat de jonction 7 ne comporte plus le canal d'entrée/sortie 14 de la figure 1, lequel a été déporté au niveau du module 12 de dérivation ; et
- le dispositif 13 de blocage est disposé à l'intérieur du module 12 de dérivation du boîtier cryostat de jonction 7, entre le canal 14 d'entrée/sortie et la dérivation 15 d'entrée/sortie. Tout comme dans le premier mode de réalisation, ce dispositif 13 de blocage est disposé autour et en contact de l'écran 4b de la deuxième portion 1b de longueur de câble.

Dans l'exemple non limitatif de la figure 2 et comme représenté par les flèches, le canal 14 d'entrée/sortie est utilisé comme une sortie du fluide cryogénique circulant dans la première portion 1a de câble puis dans le boîtier cryostat de jonction 7 puis dans le module 12 de dérivation, et la dérivation 15 est utilisée comme une sortie du fluide cryogénique circulant dans la deuxième portion 1b de câble puis dans le module 12 de dérivation. Dans la suite, on appelle « arrangement A' » la combinaison du boîtier cryostat de jonction 7, avec son connecteur 10 pour connecter en série les deux portions 1a, 1b de longueur de câble supraconducteur, et du module 12 de dérivation, muni du dispositif 13 de blocage disposé entre le canal 14 et la dérivation 15. On note ici que la distance entre le boîtier 7 et le module de dérivation 12 peut être plus ou moins importante.

Dans tous les cas, l'invention telle qu'elle vient d'être décrite dans les deux modes de réalisation précédents permet d'appliquer, comme cela va être à présent détaillé, différentes configurations permettant toutes de gérer efficacement la température et la pression des flux de fluides cryogéniques.

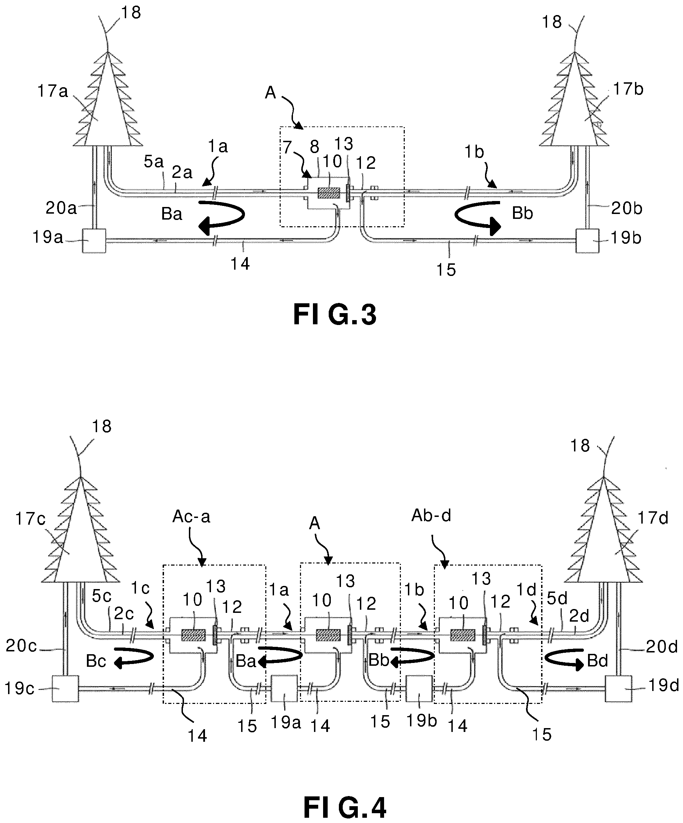

La figure 3 illustre schématiquement une première configuration possible pour la gestion du refroidissement et de la pression de fluides cryogéniques pour un exemple de circuit électrique câblé supraconducteur :

Le circuit électrique câblé utilise l'arrangement A décrit en relation avec la figure 1, et comprenant le boîtier cryostat de jonction 7 avec son connecteur 10 pour connecter en série les deux portions 1a, 1b de longueur de câble supraconducteur, son dispositif 13 de blocage et son canal de sortie 14, le module 12 de dérivation avec sa dérivation de sortie 15. Bien entendu, l'arrangement A' de la figure 2 pourrait également être utilisé à la place de l'arrangement A. L'extrémité de la première portion 1a de longueur de câble supraconducteur opposée à celle s'étendant dans le boîtier cryostat de jonction de l'arrangement A est connectée à une première terminaison 17a reliée électriquement à un réseau électrique 18. De même, l'extrémité de la deuxième portion 1b de longueur de câble supraconducteur opposée à celle s'étendant dans le boîtier cryostat de jonction de l'arrangement A est connectée à une deuxième terminaison 17b reliée électriquement également au réseau électrique 18. Le circuit électrique résultant constitue par un exemple une phase d'un réseau électrique de distribution.

Le circuit comporte un premier système de refroidissement 19a relié d'une part, à la première terminaison 17a via une première ligne 20a de transfert cryogénique et, d'autre part, à l'arrangement A via le canal 14 d'entrée /sortie, pour former une boucle Ba fermée de circulation d'un premier fluide cryogénique. Ce système de refroidissement 19a est configuré pour refroidir et mettre sous pression le premier fluide cryogénique circulant dans la première portion 1a de longueur de câble supraconducteur et reçu via le canal 14 d'entrée/sortie et pour le réinjecter dans la première portion 1a de longueur de câble supraconducteur via la première ligne 20a de transfert cryogénique.

Le circuit représenté comporte en outre un deuxième système de refroidissement 19b relié d'une part, à la deuxième terminaison 17b via une deuxième ligne 20b de transfert cryogénique et, d'autre part, à l'arrangement A via la dérivation 15 d'entrée /sortie, pour former une boucle Bb fermée de circulation d'un deuxième fluide cryogénique. Ce système de refroidissement 19b est configuré pour refroidir et mettre sous pression le deuxième fluide cryogénique circulant dans la deuxième portion 1b de longueur de câble supraconducteur et reçu via la dérivation 15 d'entrée/sortie et pour le réinjecter dans la deuxième portion 1b de longueur de câble supraconducteur via la deuxième ligne 20b de transfert cryogénique.

On a donc créé ici deux boucles fermées Ba et Bb de circulation de fluide cryogénique indépendantes l'une de l'autre. Les deux fluides cryogéniques utilisés pour ces boucles Ba et Bb peuvent être de même nature ou de nature différente. Dans tous les cas, le premier fluide cryogénique qui circule en sortie du canal de sortie 14 présente une température plus élevée et une pression plus faible que celles de ce même fluide injecté en entrée de la première portion 1a de longueur de câble au niveau de la terminaison 17a, mais le système de refroidissement 19a permet de réajuster la température et la pression de ce fluide pour un fonctionnement optimal de la portion 1a de longueur de câble supraconducteur. De même, le deuxième fluide cryogénique qui circule en sortie de la dérivation de sortie 15 présente une température plus élevée et une pression plus faible que celles de ce même fluide injecté en entrée de la portion 1b de longueur de câble au niveau de la terminaison 17b, mais le système de refroidissement 19b permet de réajuster la température et la pression de ce fluide pour un fonctionnement optimal de la deuxième portion 1b de longueur de câble supraconducteur. Le sens de circulation du fluide dans l'une quelconque des deux boucles de circulation peut être interverti.

La figure 4 illustre schématiquement une deuxième configuration possible pour la gestion du refroidissement et de la pression de fluides cryogéniques pour un exemple de circuit électrique câblé supraconducteur :

Ici, le principe décrit en référence à la figure 3 est étendu à plusieurs portions de longueurs de câbles supraconducteur, ici quatre portions 1a, 1b, 1c et 1d de longueur de câble supraconducteur connectées en série.

On retrouve un premier arrangement A tel que celui décrit en figure 3 pour relier une première portion 1a de longueur de câble supraconducteur en série avec une deuxième portion 1b de longueur de câble supraconducteur.

Le circuit comprend en outre une troisième portion 1c de longueur de câble supraconducteur, comprenant, comme pour la première portion 1a et la deuxième portion 1b, un coeur 2c de câble supraconducteur, une couche d'isolation électrique (non représentée) entourant le coeur 2c de câble supraconducteur, un écran (non représenté) entourant la couche d'isolation électrique et une enveloppe cryogénique 5c entourant l'écran pour permettre la circulation d'un fluide cryogénique dans un espace annulaire délimité par l'écran et l'enveloppe cryogénique 5c.

Cette troisième portion 1c est connectée électriquement en série avec la première portion 1a de câble. Pour ce faire, le circuit comporte un deuxième arrangement Ac-a similaire au premier arrangement A. Ainsi, le deuxième arrangement Ac-a comprend :
- son propre boîtier cryostat de jonction avec son propre connecteur 10 connectant électriquement en série la troisième portion 1c et l'extrémité de la première portion 1a opposée à celle s'étendant dans le boîtier cryostat de jonction 7 du premier arrangement A,
- son propre canal 14 d'entrée/sortie pour fluide cryogénique,
- son propre module 12 de dérivation comprenant au moins une dérivation 15 d'entrée/sortie de l'écoulement d'au moins un fluide cryogénique dans la première portion 1a de longueur de câble supraconducteur ; et
- son propre dispositif 13 de blocage de passage de fluide cryogénique interposé entre le canal 14 d'entrée/sortie du deuxième arrangement Ac-a et la dérivation 15 d'entrée/sortie du deuxième arrangement Ac-a, le dispositif 13 de blocage étant disposé ici autour et en contact de l'écran de la première portion 1a de longueur de câble supraconducteur.

Le circuit comporte un premier système de refroidissement 19a relié d'une part, directement au canal 14 d'entrée /sortie du premier arrangement A, et d'autre part, à la dérivation 15 d'entrée/sortie du deuxième arrangement Ac-a pour former une boucle Ba fermée de circulation d'un premier fluide cryogénique. Le premier système de refroidissement 19a est configuré pour refroidir et mettre sous pression le premier fluide cryogénique circulant dans la première portion 1a de longueur de câble supraconducteur et reçu via le canal 14 d'entrée/sortie du premier arrangement A et pour le réinjecter dans la première portion 1a de longueur de câble supraconducteur via la dérivation 15 d'entrée/sortie du deuxième arrangement Ac-a.

Le circuit comprend en outre une quatrième portion 1d de longueur de câble supraconducteur, comprenant, comme pour les autres portions 1a à 1c, un coeur 2d de câble supraconducteur, une couche d'isolation électrique (non représentée) entourant le coeur 2d de câble supraconducteur, un écran (non représenté) entourant la couche d'isolation électrique et une enveloppe cryogénique 5d entourant l'écran pour permettre la circulation d'un fluide cryogénique dans un espace annulaire délimité par l'écran et l'enveloppe cryogénique 5d.

Cette quatrième portion 1d est connectée électriquement en série avec la deuxième portion 1b de câble. Pour ce faire, le circuit comporte un troisième arrangement Ab-d similaire au premier arrangement A et au deuxième arrangement Ac-a. Ainsi, le troisième arrangement Ab-d comprend :
- son propre boîtier cryostat de jonction avec son propre connecteur 10 connectant électriquement en série la quatrième portion 1d et l'extrémité de la deuxième portion 1b opposée à celle s'étendant dans le boîtier cryostat de jonction 7 du premier arrangement A,
- son propre canal 14 d'entrée/sortie pour fluide cryogénique,
- son propre module 12 de dérivation comprenant au moins une dérivation 15 d'entrée/sortie de l'écoulement d'au moins un fluide cryogénique dans la quatrième portion 1d de longueur de câble supraconducteur ; et
- son propre dispositif 13 de blocage de passage de fluide cryogénique interposé entre le canal 14 d'entrée/sortie du troisième arrangement Ab-d et la dérivation 15 d'entrée/sortie du troisième arrangement Ab-d, le dispositif 13 de blocage étant disposé ici autour et en contact de l'écran de la quatrième portion 1d de longueur de câble supraconducteur.

Le circuit comporte un deuxième système de refroidissement 19b relié directement au canal 14 d'entrée /sortie du troisième arrangement Ab-d et à la dérivation 15 d'entrée/sortie du premier arrangement A pour former une boucle Bb fermée de circulation d'un deuxième fluide cryogénique. Le deuxième système de refroidissement 19b est configuré pour refroidir et mettre sous pression le deuxième fluide cryogénique circulant dans la deuxième portion 1b de longueur de câble supraconducteur et reçu via le canal 14 d'entrée/sortie du troisième arrangement Ab-d et pour le réinjecter dans la deuxième portion 1b de longueur de câble supraconducteur via la dérivation 15 d'entrée/sortie du premier arrangement A.

Par ailleurs, l'extrémité de la troisième portion 1c de longueur de câble supraconducteur opposée à celle s'étendant dans le boîtier cryostat de jonction de l'arrangement Ac-a est connectée à une première terminaison 17c reliée électriquement à un réseau électrique 18. De même, l'extrémité de la quatrième portion 1d de longueur de câble supraconducteur opposée à celle s'étendant dans le boîtier cryostat de jonction de l'arrangement Ab-d est connectée à une deuxième terminaison 17d reliée électriquement également au réseau électrique 18. Le circuit électrique résultant constitue par un exemple une phase d'un réseau électrique de distribution.

Le circuit comporte un troisième système de refroidissement 19c relié d'une part, à la première terminaison 17c via une première ligne 20c de transfert cryogénique et, d'autre part, à l'arrangement Ac-a via le canal 14 d'entrée /sortie, pour former une boucle Bc fermée de circulation d'un troisième fluide cryogénique. Ce système de refroidissement 19c est configuré pour refroidir et mettre sous pression le troisième fluide cryogénique circulant dans la troisième portion 1c de longueur de câble supraconducteur et reçu via le canal 14 d'entrée/sortie et pour le réinjecter dans la troisième portion 1c de longueur de câble supraconducteur via la première ligne 20c de transfert cryogénique.

Le circuit représenté comporte enfin un quatrième système de refroidissement 19d relié d'une part, à la deuxième terminaison 17d via une deuxième ligne 20d de transfert cryogénique et, d'autre part, à l'arrangement Ab-d via la dérivation 15 d'entrée /sortie, pour former une boucle Bd fermée de circulation d'un quatrième fluide cryogénique. Ce système de refroidissement 19d est configuré pour refroidir et mettre sous pression le quatrième fluide cryogénique circulant dans la quatrième portion 1d de longueur de câble supraconducteur et reçu via la dérivation 15 d'entrée/sortie et pour le réinjecter dans la quatrième portion 1d de longueur de câble supraconducteur via la deuxième ligne 20d de transfert cryogénique.

On a donc créé ici quatre boucles fermées Ba, Bb, Bc et Bd de circulation de fluide cryogénique indépendantes les unes des autres. Chaque boucle fermée gère, de façon indépendante, la pression et la température de l'une des portions de longueur de câble. Cela permet en particulier de prendre en compte le fait que les portions 1a à 1d peuvent avoir des longueurs différentes.

Dans l'exemple montré sur la figure 4, le sens de circulation du fluide dans l'une quelconque des quatre boucles de circulation Ba à Bd peut être interverti. De plus, pour chacun des arrangements A, Ac-a et Ab-d, on peut également utiliser l'arrangement de type A' de la figure 2 au lieu de l'arrangement de type A de la figure 1. En outre, bien que la figure 4 montre quatre portions de longueurs de câble supraconducteur reliées bout à bout par trois arrangements de type A, le principe peut être étendu à N portions de longueur de câble supraconducteurs (N supérieur à 2) reliées en série au moyen de (N-1) arrangements A ou A'.

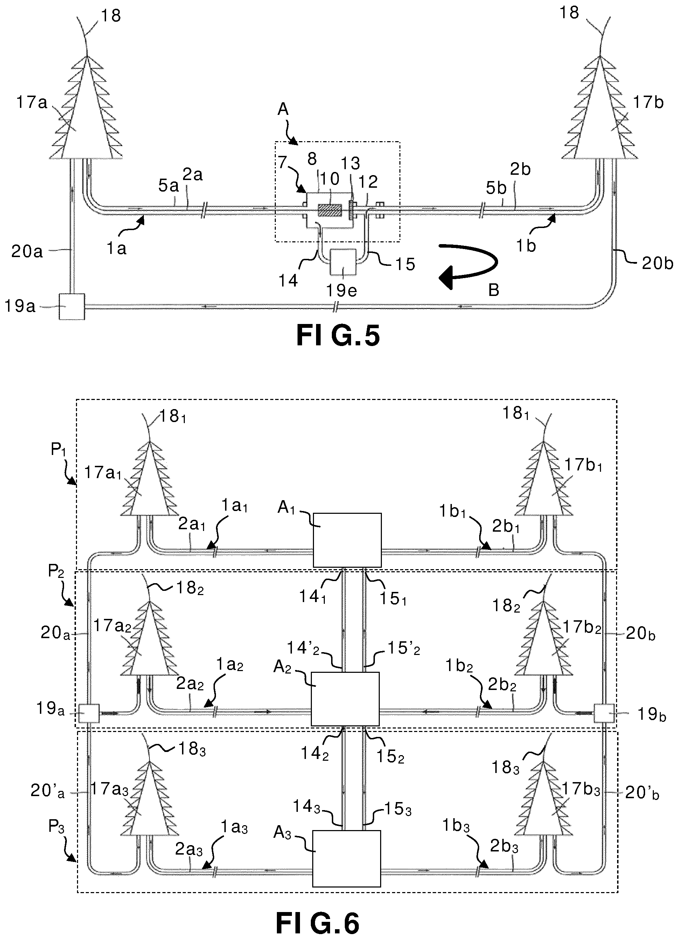

La figure 5 illustre schématiquement une troisième configuration possible pour la gestion du refroidissement et de la pression de fluides cryogéniques pour un exemple de circuit électrique câblé supraconducteur :

Ici, il ne s'agit pas de créer une boucle de circulation associée à chaque portion de longueur de câble, mais de gérer efficacement la pression et la température d'un seul fluide cryogénique circulant dans toutes les portions de longueurs de câble mises en série.

Le circuit électrique câblé utilise l'arrangement A décrit en relation avec la figure 1, et comprenant le boîtier cryostat de jonction 7 avec son connecteur 10 pour connecter en série les deux portions 1a, 1b de longueur de câble supraconducteur, son dispositif 13 de blocage et son canal 14 d'entrée/sortie, le module 12 de dérivation avec sa dérivation 15 d'entrée/sortie. Bien entendu, l'arrangement A' de la figure 2 pourrait également être utilisé à la place de l'arrangement A. Les deux autres extrémités des portions 1a et 1b de longueur de câble supraconducteur sont connectées chacune à une terminaison 17a, 17b, elle-même reliée électriquement au réseau électrique 18. Ici encore, le circuit électrique résultant constitue par un exemple une phase d'un réseau électrique de distribution.

Un système de refroidissement 19e est relié directement au canal 14 d'entrée /sortie et à la dérivation 15 d'entrée/sortie de l'arrangement A, ce système de refroidissement 19e étant configuré pour refroidir et mettre sous pression le fluide cryogénique circulant dans la première portion 1a de longueur de câble supraconducteur et reçu via le canal 14 d'entrée/sortie et pour le réinjecter dans la deuxième portion 1b de longueur de câble supraconducteur via la dérivation 15 d'entrée/sortie.

Le circuit de la figure 5 comporte enfin un système de refroidissement additionnel 19a relié à la première terminaison 17a via une première ligne 20a de transfert cryogénique et à la deuxième terminaison 17b via une deuxième ligne 20b de transfert cryogénique pour former une boucle B fermée de circulation du fluide cryogénique. Le système de refroidissement additionnel 19a est configuré pour refroidir et mettre sous pression le fluide cryogénique circulant dans la deuxième portion 1b de longueur de câble supraconducteur et reçu via la deuxième ligne 20b de transfert cryogénique et pour le réinjecter dans la première portion 1a de longueur de câble supraconducteur via la première ligne 20a de transfert cryogénique.

Il n'y a donc qu'une seule boucle B de flux de fluide cryogénique dans cette troisième configuration (à l'opposé des précédentes qui ont deux ou plusieurs boucles indépendantes). Ici encore, le sens de circulation du fluide peut être interverti, la dérivation 15 étant utilisée comme entrée et le canal 14 étant utilisé comme sortie. En outre, bien que la figure 5 ne montre que deux portions de longueurs de câble supraconducteur reliées bout à bout par un arrangement de type A, le principe peut être étendu à N portions de longueur de câble supraconducteurs (N étant supérieur à 2) reliées en série au moyen de (N-1) arrangements A ou A'.

Dans les trois configurations précédentes décrites en relation avec les figures 3 à 5, l'ensemble câblé relié au réseau 18 via les deux terminaisons 17a et 17b, et constitué des portions de longueur de câbles connectées deux à deux en série peut correspondre à une phase d'un système monophasé ou triphasé.

Si le système est triphasé, il est possible de répliquer l'une quelconque des configurations précédentes pour chacune des trois phases du système.

Une autre possibilité particulièrement adaptée au cas d'un système triphasé est décrite en référence à la figure 6 :

Le système comporte trois phases P₁, P₂ et P₃. Chaque phase Pᵢ (l'entier i étant égal à 1, 2 ou 3) comporte :
- une première portion 1aᵢ de longueur de câble supraconducteur et une deuxième portion 1bᵢ de longueur de câble supraconducteur reliées en série via un arrangement Aᵢ ;
- deux terminaisons 17aᵢ et 17bᵢ auxquelles sont reliées les extrémités de la première, respectivement deuxième, portion 1aᵢ, 1bᵢ de longueur de câble supraconducteur opposée à celle s'étendant dans le boîtier cryostat de jonction (non représenté) de l'arrangement Aᵢ, ces deux terminaisons 17aᵢ et 17bᵢ étant elles-mêmes reliées électriquement à une phase 18ᵢ d'un réseau électrique triphasé.

Les portions 1aᵢ, 1bᵢ de longueur de câble supraconducteur comportent toutes un coeur 2aᵢ, 2bᵢ de câble supraconducteur, une couche d'isolation électrique (non représentée) entourant le coeur 2aᵢ, 2bᵢ de câble supraconducteur, un écran (non représenté) entourant la couche d'isolation électrique et une enveloppe cryogénique entourant l'écran pour permettre la circulation d'un fluide cryogénique dans un espace annulaire délimité par l'écran et l'enveloppe cryogénique. Les arrangements Aᵢ sont soit du type A (décrit en référence à la figure 1), soit du type A' (décrit en référence à la figure 2). Pour simplifier la figure, chaque arrangement Aᵢ est ainsi représenté uniquement avec son canal 14ᵢ d'entrée sortie et sa dérivation 15ᵢ d'entrée/sortie. Chaque arrangement comporte donc, conformément au principe de l'invention, un boîtier cryostat de jonction (non représenté) pour connecter électriquement en série la première portion 1aᵢ et la deuxième portion 1bᵢ, un module de dérivation (non représenté), et un dispositif de blocage de passage de fluide cryogénique (non représenté) interposé entre le canal 14ᵢ d'entrée/de sortie et la dérivation 15ᵢ d'entrée/sortie, le dispositif de blocage étant disposé autour et en contact de l'écran de la deuxième portion 1bᵢ de longueur de câble supraconducteur.

Les deux arrangements A₁ et A₃ sont ici identiques en ce qu'ils comportent un unique canal 14₁, respectivement 14₃ d'entrée/sortie, et une unique dérivation 15₁, respectivement 15₃ d'entrée/sortie. L'arrangement A₂ associé à la phase centrale, ici la phase P₂, comprend en outre un canal 14'₂ d'entrée/sortie et une dérivation 15'₂ d'entrée/sortie additionnels. Comme visible sur la figure 6, le canal 14₂ et la dérivation 15₂ de l'arrangement A₂ sont connectés respectivement au canal 14₃ et à la dérivation 15₃ de l'arrangement A₃ associé à la phase P₃, alors que le canal additionnel 14'₂ et la dérivation additionnelle 15'₂ de l'arrangement A₂ sont connectés respectivement au canal 14₁ et à la dérivation 15₁ de l'arrangement A₁ associé à la phase P₁.

Un premier flux principal de fluide cryogénique est injecté par un premier système de refroidissement 19a préférentiellement dans la portion 1a₂ de la phase centrale P₂ à travers la terminaison correspondante 17a₂. Grâce à la présence du canal 14₂ et du canal additionnel 14'₂ du boîtier cryostat de jonction et du dispositif de blocage de l'arrangement A₂, ce premier flux principal est divisé en deux. Chaque demi-flux est respectivement dirigé vers le boîtier cryostat de jonction de l'arrangement A₁, respectivement A₃, par l'intermédiaire de leur canal 14₁, respectivement 14₃. Grâce au dispositif de blocage du flux implanté chaque arrangement A₁, A₃, chacun de ces deux demi-flux repart ensuite le long des premières portions 1a₁, respectivement 1a₃, vers les terminaisons associées 17a₁, respectivement 17as. Ensuite, chaque demi-flux retourne au premier système de refroidissement 19a à travers une ligne de transfert correspondante 20a, 20'a. Les demi-flux sont recombinés pour être réinjectés de nouveau via la terminaison 17a₂, après réajustement de la pression et de la température.

Une circulation similaire est appliquée de l'autre côté du système avec un second flux principal de fluide cryogénique injecté par un second système de refroidissement 19b dans la portion 1b₂ de la phase centrale P₂ à travers la terminaison correspondante 17b₂. Grâce à la présence de la dérivation 15₂ et de la dérivation additionnelle 15'₂ du module de dérivation, et du dispositif de blocage de l'arrangement A₂, ce deuxième flux principal est divisé en deux. Chaque demi-flux est respectivement dirigé vers le module de dérivation de l'arrangement A₁, respectivement A₃, par l'intermédiaire de leur dérivation 15₁, respectivement 15₃. Grâce au dispositif de blocage du flux implanté chaque arrangement A₁, A₃, chacun de ces deux demi-flux repart ensuite le long des deuxième portions 1b₁, respectivement 1b₃, vers les terminaisons associées 17b₁, respectivement 17b₃. Ensuite, chaque demi-flux retourne au second système de refroidissement 19b à travers une ligne de transfert correspondante 20b, 20'b. Les demi-flux sont recombinés pour être réinjectés de nouveau via la terminaison 17b₂, après réajustement de la pression et de la température.

## Revendications

1. Circuit électrique câblé supraconducteur comportant :
• une première portion (1a) de longueur de câble supraconducteur et une deuxième portion (1b) de longueur de câble supraconducteur, chacune des première et deuxième portions (1a, 1b) de longueur de câble supraconducteur comprenant un coeur (2a, 2b) de câble supraconducteur, une couche d'isolation électrique (3a, 3b) entourant le coeur (2a, 2b) de câble supraconducteur, un écran (4a, 4b) de blindage entourant la couche d'isolation électrique (3a, 3b) et une enveloppe cryogénique (5a, 5b) entourant l'écran (4a, 4b) pour permettre la circulation d'un fluide cryogénique dans un espace annulaire délimité par l'écran (4a, 4b) et l'enveloppe cryogénique (5a, 5b); et
• au moins un premier arrangement (A ; A' ; A₁, A₂, A₃) comprenant un boîtier cryostat de jonction (7) connectant électriquement en série la première portion (1a) et la deuxième portion (1b), un canal (14) d'entrée/sortie pour fluide cryogénique, et un dispositif (13) de blocage de passage de fluide cryogénique disposé autour et en contact de l'écran (4b) de blindage de la deuxième portion (1b) de longueur de câble supraconducteur,
**caractérisé en ce que** ledit au moins un premier arrangement (A ; A' ; A₁, A₂, A₃) comprend en outre un module (12) de dérivation distinct dudit boîtier cryostat de jonction (7) et interposé entre le boîtier cryostat de jonction (7) et la deuxième portion (1b) de longueur de câble supraconducteur, ledit module (12) de dérivation comprenant au moins une dérivation (15) d'entrée/sortie de l'écoulement d'un fluide cryogénique dans la deuxième portion (1b) de longueur de câble supraconducteur; et **en ce que** le dispositif (13) de blocage de passage de fluide cryogénique est un disque en acier inoxydable ou en plastique renforcé de fibre de verre interposé entre ledit canal (14) d'entrée/de sortie et ladite dérivation (15) d'entrée/sortie.

2. Circuit selon la revendication 1, dans lequel ledit boîtier cryostat de jonction (7) comprend :
• deux ouvertures (9a, 9b) d'accès au travers de chacune desquelles une extrémité de la première, respectivement de la deuxième, portion (1a, 1b) de longueur de câble supraconducteur peut s'étendre, chaque ouverture (9a, 9b) étant configurée pour permettre la fixation étanche d'une extrémité de l'enveloppe cryogénique (5a, 5b) de la portion correspondante de longueur de câble supraconducteur ; et
• un connecteur (10) connectant électriquement les extrémités des deux coeurs (2a, 2b) de câble supraconducteur.

3. Circuit selon la revendication 2, dans lequel le dispositif (13) de blocage dudit arrangement (A) est disposé à l'intérieur du boîtier cryostat de jonction (7), en regard de l'ouverture d'accès (9b) traversée par la deuxième portion (1b) de longueur de câble et contre cette ouverture d'accès (9b) de manière à l'obturer, ledit boîtier cryostat de jonction (7) portant en outre ledit canal (14) d'entrée /sortie de fluide cryogénique.

4. Circuit selon la revendication 2, dans lequel le module (12) de dérivation porte ledit canal (14) d'entrée/sortie dudit arrangement (A'), et le dispositif (13) de blocage est disposé à l'intérieur du module (12) de dérivation, entre ledit canal (14) d'entrée/sortie et ladite dérivation (15) d'entrée/sortie.

5. Circuit selon l'une quelconque des revendications précédentes, comportant au moins un système de refroidissement (19a, 19b ; 19e) relié au canal (14) d'entrée /sortie et/ou à la dérivation (15) d'entrée/sortie, de façon à recevoir un fluide cryogénique circulant à l'intérieur de l'une des portions de câble.

6. Circuit selon la revendication 5, dans lequel l'extrémité de la première, respectivement deuxième, portion (1a, 1b) de longueur de câble supraconducteur opposée à celle s'étendant dans le boîtier cryostat de jonction (7) du premier arrangement (A ; A') est connectée à une première (17a), respectivement deuxième (17b), terminaison reliée électriquement à un réseau électrique (18), ledit au moins un système de refroidissement (19a) étant relié à la première terminaison (17a) via une première ligne (20a) de transfert cryogénique et audit premier arrangement (A ; A') via le canal (14) d'entrée /sortie pour former une boucle (Ba) fermée de circulation d'un premier fluide cryogénique, ledit au moins un système de refroidissement (19a) étant configuré pour refroidir et mettre sous pression le premier fluide cryogénique circulant dans la première portion (1a) de longueur de câble supraconducteur et reçu via le canal (14) d'entrée/sortie et pour le réinjecter dans la première portion (1a) de longueur de câble supraconducteur via la première ligne (20a) de transfert cryogénique.

7. Circuit selon la revendication 6, comportant un système de refroidissement additionnel (19b) relié à la deuxième terminaison (17b) via une deuxième ligne (20b) de transfert cryogénique et audit premier arrangement (A ; A') via la dérivation (15) d'entrée /sortie pour former une boucle (Bb) fermée de circulation d'un deuxième fluide cryogénique, ledit système de refroidissement additionnel (19b) étant configuré pour refroidir et mettre sous pression le deuxième fluide cryogénique circulant dans la deuxième portion (1b) de longueur de câble supraconducteur et reçu via la dérivation (15) d'entrée/sortie et pour le réinjecter dans la deuxième portion (1b) de longueur de câble supraconducteur via la deuxième ligne (20b) de transfert cryogénique.

8. Circuit selon la revendication 5, dans lequel le système de refroidissement (19e) est relié directement au canal (14) d'entrée /sortie et à la dérivation (15) d'entrée/sortie dudit premier arrangement (A ; A'), ledit système de refroidissement (19e) étant configuré pour refroidir et mettre sous pression le fluide cryogénique circulant dans la première portion (1a) de longueur de câble supraconducteur et reçu via le canal (14) d'entrée/sortie et pour le réinjecter dans la deuxième portion (1b) de longueur de câble supraconducteur via la dérivation (15) d'entrée/sortie.

9. Circuit selon la revendication 8, dans lequel l'extrémité de la première, respectivement deuxième, portion (1a, 1b) de longueur de câble supraconducteur opposée à celle s'étendant dans le boîtier cryostat de jonction (7) dudit premier arrangement (A ; A') est connectée à une première (17a), respectivement deuxième (17b), terminaison reliée électriquement à un réseau électrique (18).

10. Circuit selon la revendication 9, comportant un système de refroidissement additionnel (19a) relié à la première terminaison (17a) via une première ligne (20a) de transfert cryogénique et à la deuxième terminaison (17b) via une deuxième ligne (20b) de transfert cryogénique pour former une boucle (B) fermée de circulation du fluide cryogénique, ledit système de refroidissement additionnel (19a) étant configuré pour refroidir et mettre sous pression le fluide cryogénique circulant dans la deuxième portion (1b) de longueur de câble supraconducteur et reçu via la deuxième ligne (20b) de transfert cryogénique et pour le réinjecter dans la première portion (1a) de longueur de câble supraconducteur via la première ligne (20a) de transfert cryogénique.

11. Circuit selon la revendication 5, comprenant :
• une troisième portion (1c) de longueur de câble supraconducteur comprenant un coeur (2c) de câble supraconducteur, une couche d'isolation électrique entourant le coeur (2c) de câble supraconducteur, un écran entourant la couche d'isolation électrique et une enveloppe cryogénique (5c) entourant l'écran pour permettre la circulation d'un fluide cryogénique dans un espace annulaire délimité par l'écran et l'enveloppe cryogénique (5c) ; et
• un deuxième arrangement (Ac-a) comprenant un boîtier cryostat de jonction (7) connectant électriquement en série la troisième portion (1c) et l'extrémité de la première portion (1a) opposée à celle s'étendant dans le boîtier cryostat de jonction (7) du premier arrangement (A), un canal (14) d'entrée/sortie pour fluide cryogénique, un module (12) de dérivation comprenant au moins une dérivation (15) d'entrée/sortie de l'écoulement d'au moins un fluide cryogénique dans la première portion (1a) de longueur de câble supraconducteur; et un dispositif (13) de blocage de passage de fluide cryogénique interposé entre ledit canal (14) d'entrée/ sortie du deuxième arrangement (Ac-a) et ladite dérivation (15) d'entrée/sortie du deuxième arrangement (Ac-a), le dispositif (13) de blocage étant disposé autour et en contact de l'écran (4a) de la première portion (1a) de longueur de câble supraconducteur,
dans lequel le système de refroidissement (19a) est relié directement au canal (14) d'entrée /sortie du premier arrangement (A) et à la dérivation (15) d'entrée/sortie du deuxième arrangement (Ac-a) pour former une boucle (Ba) fermée de circulation d'un premier fluide cryogénique, ledit système de refroidissement (19a) étant configuré pour refroidir et mettre sous pression le premier fluide cryogénique circulant dans la première portion (1a) de longueur de câble supraconducteur et reçu via le canal (14) d'entrée/sortie du premier arrangement (A) et pour le réinjecter dans la première portion (1a) de longueur de câble supraconducteur via la dérivation (15) d'entrée/sortie du deuxième arrangement (Ac-a).

12. Circuit selon la revendication 11, comprenant :
• une quatrième portion (1d) de longueur de câble supraconducteur comprenant un coeur (2d) de câble supraconducteur, une couche d'isolation électrique entourant le coeur (2d) de câble supraconducteur, un écran entourant la couche d'isolation électrique et une enveloppe cryogénique (5d) entourant l'écran pour permettre la circulation d'un fluide cryogénique dans un espace annulaire délimité par l'écran et l'enveloppe cryogénique (5d) ;
• un troisième arrangement (Ab-d) comprenant un boîtier cryostat de jonction (7) connectant électriquement en série la quatrième portion (1d) et l'extrémité de la deuxième portion (1b) opposée à celle s'étendant dans le boîtier cryostat de jonction (7) du premier arrangement (A), un canal (14) d'entrée/sortie pour fluide cryogénique, un module (12) de dérivation comprenant au moins une dérivation (15) d'entrée/sortie de l'écoulement d'au moins un fluide cryogénique dans la quatrième portion (1d) de longueur de câble supraconducteur; et un dispositif (13) de blocage de passage de fluide cryogénique interposé entre ledit canal (14) d'entrée/ sortie du troisième arrangement (Ab-d) et ladite dérivation (15) d'entrée/sortie du troisième arrangement (Ab-d), le dispositif (13) de blocage étant disposé autour et en contact de l'écran de la quatrième portion (1d) de longueur de câble supraconducteur ; et
• un système de refroidissement additionnel (19b) relié directement au canal (14) d'entrée /sortie du troisième arrangement (Ab-d) et à la dérivation (15) d'entrée/sortie du premier arrangement (A) pour former une boucle (Bb) fermée de circulation d'un deuxième fluide cryogénique, ledit système de refroidissement additionnel (19b) étant configuré pour refroidir et mettre sous pression le deuxième fluide cryogénique circulant dans la deuxième portion (1b) de longueur de câble supraconducteur et reçu via le canal (14) d'entrée/sortie du troisième arrangement (Ab-d) et pour le réinjecter dans la deuxième portion (1b) de longueur de câble supraconducteur via la dérivation (15) d'entrée/sortie du premier arrangement (A).

13. Circuit selon l'une quelconque des revendications 1 à 4, dans lequel l'extrémité de la première, respectivement deuxième, portion (1a, 1b) de longueur de câble supraconducteur opposée à celle s'étendant dans le boîtier cryostat de jonction du premier arrangement (A) est connectée à une première (17a), respectivement deuxième (17b), terminaison reliée électriquement à une phase (18) d'un réseau électrique.

14. Système triphasé comprenant trois circuits électriques câblés supraconducteurs selon la revendication 13 définissant chacun une phase (P1 à P3) du système.

15. Système triphasé selon la revendication 14, dans lequel le premier arrangement (A2) d'une première phase (P2) parmi les trois phases (P1 à P3) du système comporte un canal (14'2) d'entrée/sortie additionnel et une dérivation (15'2) d'entrée/sortie additionnelle, et est connecté aux premiers arrangements (A1, A3) de chacune des deux autres phases de façon à ce que :
• son canal (14₂) d'entrée/sortie et sa dérivation (15₂) d'entrée/sortie soient connectés respectivement au canal (14₃) d'entrée/sortie et à la dérivation (15₃) du premier arrangement (A₃) associé à une deuxième phase (P₃) parmi les trois phases ;
• son canal (14'₂) d'entrée/sortie additionnel et sa dérivation (15'₂) d'entrée/sortie additionnelle soient connectés respectivement au canal (14₁) d'entrée/sortie et à la dérivation (15₁) d'entrée/sortie du premier arrangement (A₁) associé à une troisième phase (P₁) parmi les trois phases.

16. Système triphasé selon la revendication 15, comportant en outre :
• un premier système de refroidissement (19a) injectant un premier flux principal de fluide cryogénique dans la première portion (1a₂) de longueur de câble de la première phase (P₂) à travers la terminaison correspondante (17a2) ;
• un second système de refroidissement (19b) injectant un second flux principal de fluide cryogénique dans la deuxième portion (1b₂) de longueur de câble de la première phase (P₂) à travers la terminaison correspondante (17b2).
dans lequel le premier, respectivement le deuxième, flux principal est divisé par le premier arrangement (A₂) de la première phase (P₂) en deux demi-flux, puis recombinés par le premier (19a), respectivement le deuxième (19b), système de refroidissement pour être réinjectés de nouveau, après réajustement de la pression et de la température, dans la première (1a₂), respectivement la deuxième (1b₂), portion de longueur de câble de la première phase (P₂).
